Europäisches Patentamt

European Patent Office

Office européen des brevets

(19)

(11) Numéro de publication: **0 136 228 B1**

(12) **FASCICULE DE BREVET EUROPEEN**

(45) Date de publication du fascicule du brevet:
**07.01.88**

(51) Int. Cl.⁴: **H 03 K 17/78**, H 04 B 9/00

(21) Numéro de dépôt: **84401817.6**

(22) Date de dépôt: **13.09.84**

(54) Circuit isolateur à coupleur optoélectonique.

(30) Priorité: **20.09.83 FR 8314920**

(43) Date de publication de la demande:
**03.04.85 Bulletin 85/14**

(45) Mention de la délivrance du brevet:
**07.01.88 Bulletin 88/1**

(84) Etats contractants désignés:
**BE CH DE GB IT LI NL SE**

(56) Documents cités:
**ELECTRONIC ENGINEERING, vol. 46, no. 556, juin 1974, pages 46-48, Londres, GB; P. TURNER: "Faster optically-coupled isolator is compatible with t.t.l. interfaces"**

(73) Titulaire: **Leseure, Jean-Yves, 7, rue Papu, F-35000 Rennes (FR)**
Titulaire: **Etablissement Public de Diffusion dit "Télédiffusion de France", 21-27 rue Barbès, F-92120 Montrouge (FR)**

(72) Inventeur: **Leseure, Jean-Yves, 7, rue Papu, F-35000 Rennes (FR)**
Inventeur: **Charbonnel, Pierre, 2, rue Surcouf, F-35830 Betton (FR)**
Inventeur: **Laure, Christian, 13, rue du Parc, F-35830 Betton (FR)**

(74) Mandataire: **Mongrédien, André et al, c/o BREVATOME 25, rue de Ponthieu, F-75008 Paris (FR)**

## Description

La présente invention a pour objet un circuit isolateur à coupleur optoélectronique. Elle trouve une application en électronique, notamment dans la réalisation d'équipements analogiques ou numériques. A propos de ces derniers, on peut citer par exemple les codeurs-décodeurs («codecs») numériques audiofréquence.

Les matériels de radiodiffusion audio, ainsi que la plupart des équipements de sonorisation, comportent des transformateurs d'entrée et de sortie, dont le rôle est d'assurer l'isolement galvanique entre les différents sous-ensembles de la chaîne audiofréquence.

On sait par ailleurs qu'un isolement galvanique peut être obtenu par des coupleurs optoélectroniques. Ces dispositifs comprennent une diode photoémettrice disposée en regard d'un photodétecteur, un circuit de polarisation de la diode photoémettrice et un amplificateur de sortie connecté au photodétecteur.

Chacun de ces deux dispositifs présente des inconvénients. Les transformateurs d'isolement sont réservés au domaine professionnel (radiodiffusion, production, mesures), ou semi-professionnel (sonorisation), en raison de leur prix élevé. Les composants ayant des performances de type professionnel (grande régularité de la bande passante, faible distorsion) sont particulièrement onéreux, surtout s'ils doivent accepter une amplitude de signal importante, de l'ordre d'une vingtaine de décibels. Pour de tels niveaux, la distorsion aux fréquences basses devient vite prohibitive, en raison de la saturation du noyau magnétique, à moins d'augmenter le volume de la caracasse.

A titre indicatif, un transformateur d'isolement professionnel de 600 Ω d'impédance occupe un volume de 0,2 à 0,4 litre, et son prix se situe entre 400 et 600F (1983); en outre, du fait de la technologie utilisée, ce prix ne peut qu'augmenter.

Si les coupleurs optoélectroniques ne présentent pas ces inconvénients, il faut en revanche souligner que la présence d'une polarisation continue de la diode émettrice est très contraignante dans le cas d'un équipement à plusieurs entrées: il est alors nécessaire de transporter une ligne d'alimentation par entrée, ce qui est peu commode. Par ailleurs, le schéma de branchement classique de ce composant n'assure pas la compatibilité avec les transformateurs d'isolement magnétique éventuellement utilisés par ailleurs, et ceci dans la mesure où la polarisation de la diode émettrice doit être assurée par le circuit amont.

Le but de l'invention est justement de remédier à cet inconvénient en proposant un circuit optoélectronique pouvant remplacer les transformateurs d'entrée à haute impédance notamment dans les équipements audiofréquences. Ce circuit assure les mêmes fonctions qu'un transformateur d'isolement avec une dynamique au moins égale, et un encombrement et un prix inférieurs.

A cette fin, on utilise selon l'invention, un coupleur optoélectronique dont le circuit de polarisation est particulier et est du type haute-fréquence; ainsi s'affranchit-on de la nécessité de transporter une ligne d'alimentation spéciale pour chacune des entrées audiofréquences pour polariser les diodes des coupleurs utilisés.

De façon précise, l'invention a donc pour objet un circuit isolateur comprenant:

– un coupleur optoélectronique composé d'une diode photoémettrice disposée en regard d'un photodétecteur,

– un circuit de polarisation de la diode photoémettrice,

– une entrée de signal connectée à la diode photoémettrice et un amplificateur de sortie connecté au photodétecteur, ce circuit isolateur étant caractérisé par le fait que le circuit de polarisation de la diode photoémettrice comprend une source de tension haute-fréquence reliée à un transformateur haute-fréquence et un circuit redresseur inséré entre ce transformateur et la diode photoémettrice.

Selon un premier mode de réalisation, le circuit redresseur comprend une diode ou un pont de diodes et un condensateur.

Selon un autre mode de réalisation, le circuit de polarisation comprend une résistance et un condensateur.

Selon une variante avantageuse, la source de tension haute fréquence est constituée par des moyens appartenant à l'équipement sur lequel le circuit isolateur est implanté.

De toute façon, l'invention sera mieux comprise après la description qui suit, d'exemples de réalisation donnés à titre explicatif et nullement limitatif. Cette description se réfère à des dessins annexés sur lesquels:

– la figure 1 représente un isolateur optoélectronique selon l'art antérieur,

– la figure 2 représente un circuit isolateur selon l'invention,

– la figure 3 illustre une variante à entrées symétriques avec circuits redresseurs séparés,

– la figure 4 illustre une autre variante à entrées symétriques avec circuit redresseur commun,

– la figure 5 montre un circuit de sortie de type symétrique,

– la figure 6 montre un autre circuit de sortie de type dissymétrique.

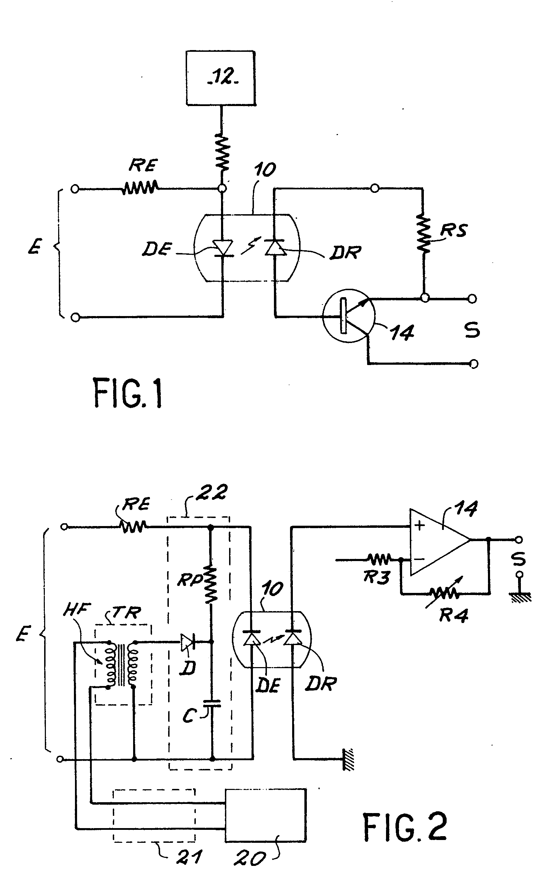

Le circuit isolateur illustré par la figure 1 est du genre de ceux qui comprennent un coupleur optoélectronique 10, composé d'une diode émettrice DE disposée en regard d'une diode photoréceptrice DR, un circuit 12 de polarisation de la diode émettrice DE, une entrée de signal E connectée à la diode émettrice par une résistance RE et un amplificateur de sortie 14 connecté à la diode photoréceptrice par une résistance de sortie RS et une sortie de signal S.

L'originalité du circuit de l'invention tient dans la structure du circuit de polarisation. Elle est illustrée par la figure 2. L'isolateur représenté possède un circuit de polarisation de la diode photoémettrice DE qui comprend une source de tension haute fréquence 20 reliée à un transformateur haute fréquence TR et un circuit redresseur

22 inséré entre ce transformateur et la diode photoémettrice.

Tel que représenté sur la figure 2, le circuit redresseur 22 comprend une diode D, un condensateur C et une résistance RP.

Le principe de fonctionnement de ce circuit de polarisation est le suivant. Le transformateur basse impédance TR transmet le signal de polarisation haute fréquence au circuit redresseur. La fréquence utilisée est typiquement comprise entre 2 et 20 MHz. Un transformateur au format DIL 5 broches, du type MCL T4–1 est amplement suffisant. Par ailleurs, le fait d'utiliser une fréquence élevée présente l'avantage, par rapport à l'emploi d'une alimentation flottante classique, de n'engendrer aucune ondulation parasite dans le spectre audiofréquence.

On peut utiliser un circuit redresseur plus simple en renonçant à la diode D: un simple circuit intégrateur à résistance et à condensateur peut être inséré entre le transformateur et la diode émissive. La seule condition à respecter est que la fréquence $f_A$ de coupure haute du spectre audio, soit très inférieure à $\dfrac{1}{2\pi RC}$ si R et C sont les valeurs des éléments résistif et capacitif.

Ce circuit très simple, à résistance et condensateur, présente toutefois l'inconvénient de nécessiter plus d'énergie que le précédent, avec diode. C'est la raison pour laquelle le premier peut être préféré.

Dans certains cas, on peut utiliser un circuit adaptateur 21 (en tirets sur la figure 2), pour des questions de compatibilité entre la source 20 et le reste du circuit. Il peut s'agir par exemple d'un circuit tampon en TTL («Transistor-Transistor-Logic»).

L'amplificateur 14 peut être du type tension-tension. Son gain est élevé. La résistance RP permet de régler le courant de polarisation de la diode DE et la résistance R4, le gain du circuit complet. Ces deux réglages sont fonction du circuit électrooptique utilisé. A titre explicatif, il peut être indiqué que l'on peut utiliser par exemple un coupleur 6N135, une résistance RP de 350 Ω et une résistance R3 de 1,2 k Ω et une résistance R4 de 5 M Ω. Le transformateur TR peut être du type MCL T4–1 commercialisé par Mini-Circuits et l'oscillateur de type VF180 commercialisé par Valpey Fisher.

On peut aussi utiliser une diode émettrice travaillant dans l'infrarouge et une diode réceptrice de type PIN.

Dans une variante avantageuse, le circuit oscillateur est constitué par des moyens situés dans l'équipement numérique dans lequel l'isolateur est implanté.

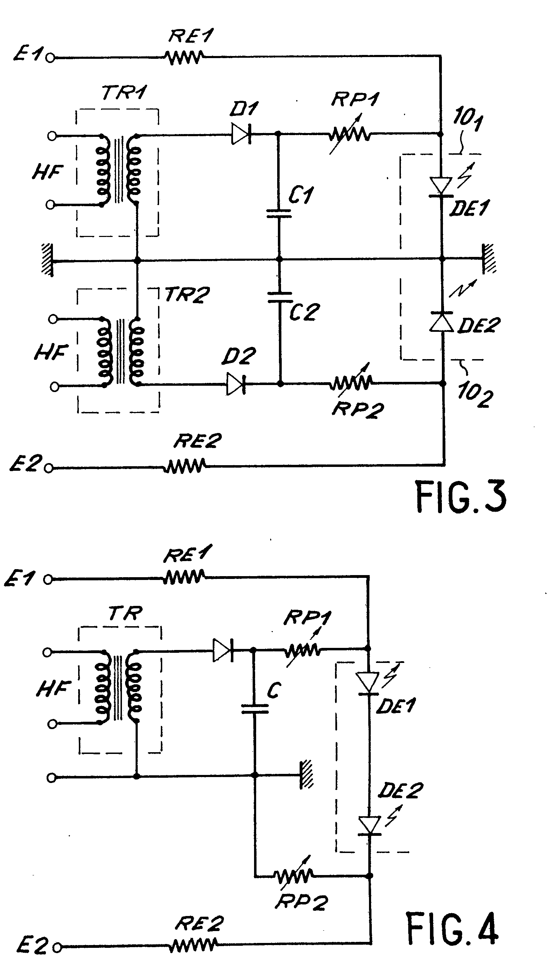

L'invention permet des montages à entrées symétriques, si l'on utilise deux opto-coupleurs 10/1 et 10/2, définissant deux voies distinctes; l'entrée symétrique comprend un point haut $E_1$ et un point bas $E_2$. Cette entrée est analogue à celle d'un transformateur symétrique. La polarisation de chaque diode émettrice peut être obtenue par des circuits séparés (figure 3) ou par un circuit commun (figure 4), selon le type de composants utilisés, et les débits nécessaires. Dans les deux variantes illustrées les éléments représentés portent les mêmes références que sur la figure 2, mais avec des indices 1 et 2 selon leur appartenance à la voie du haut ou à la voie du bas.

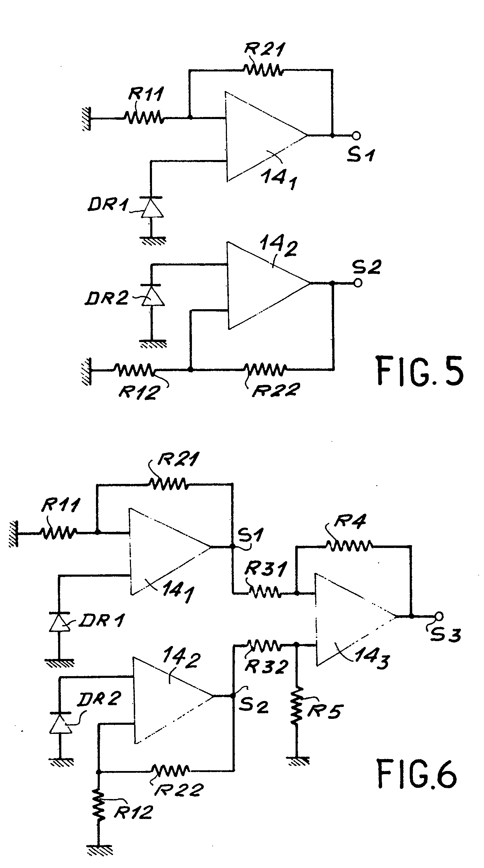

Les sorties du circuit peuvent également être symétriques (figure 5) avec une sortie S1 (point haut) et une sortei S2 (point bas). Le circuit de sortie comprenant alors un double amplificateur 14/1, 14/2 reliés aux diodes réceptrices DR1, DR2 avec des résistances de réglage R11, R21 et R12 et R22.

La sortie peut être dissymétrique (figure 6) si l'on ajoute un troisième amplificateur 14/3 de sortie S3, pourvu de deux entrées reliées aux sorties S1, S2.

Dans une variante conforme à la figure 2, les résultats suivants ont été obtenus pour un niveau d'entrée de −10 dB (correspondant au niveau ligne en sonorisation):
– distorsion harmonique de rang 2:0,3% (50 dB) de 20 Hz à 20 kHz,
– rapport signal sur bruit : 80 dB de 20 à 20 000 Hz.

## Revendications

1. Circuit isolateur comprenant:
– un coupleur optoélectronique (10) composé d'une diode photoémettrice (DE) disposée en regard d'un photodétecteur (DR),
– un circuit de polarisation de la diode photoémettrice,
– une entrée de signal (E) connectée à la diode photoémettrice (DE) et un amplificateur de sortie (14) connecté au photodétecteur (DR), ce circuit étant caractérisé par le fait que le circuit de polarisation de la diode photoémettrice comprend une source de tension haute fréquence (20) reliée à un transformateur haute fréquence (TR) et un circuit redresseur (22) inséré entre ce transformateur (TR) et la diode photoémettrice (DE).

2. Circuit isolateur selon la revendication 1, caractérisé par le fait que le circuit redresseur (22) comprend une diode (D) ou un pont de diodes et un condensateur (C).

3. Circuit isolateur selon la revendication 1, caractérisé par le fait que le circuit de polarisation comprend une résistance (RP) et un condensateur (C).

4. Circuit isolateur selon la revendication 1, caractérisé par le fait que la source de tension haute fréquence (20) est constituée par des moyens appartenant à l'équipement sur lequel le circuit isolateur est implanté.

5. Circuit isolateur selon la revendication 1, caractérisé par le fait que, dans le cas d'un signal d'entrée symétrique, le circuit de polarisation comprend deux circuits redresseurs en parallèle.

6. Circuit isolateur selon la revendication 1, caractérisé par le fait que, dans le cas d'un signal d'entrée symétrique, le circuit de polarisation comprend un seul circuit redresseur.

**Patentansprüche**

1. Isolierschaltung, die umfasst:

– einen opto-elektronischen Koppler (10), der aus einer einem Fotowandler (DR) gegenüberliegend angeordneten Leuchtdiode (DE) gebildet ist,

– einen Polarisationsschaltkreis für die Leuchtdiode,

– einen mit der Leuchtdiode (DE) verbundenen Signaleingang (E) und einen mit dem Fotowandler (DR) verbundenen Ausgangsverstärker (14), wobei dieser Schaltkreis dadurch gekennzeichnet ist, dass der Polarisationsschaltkreis für die Leuchtdiode eine Hochfrequenzspannungsquelle (20), die mit einem Hochfrequenztransformator (TR) verbunden ist, und einen Gleichrichterschaltkreis (22) umfasst, der zwischen diesem Transformator (TR) und der Leuchtdiode (DE) eingefügt ist.

2. Isolierschaltung nach Anspruch 1, dadurch gekennzeichnet, dass der Gleichrichterschaltkreis (22) eine Diode (D) oder eine Diodenbrücke und einen Kondensator (C) umfasst.

3. Isolierschaltkreis nach Anspruch 1, dadurch gekennzeichnet, dass der Polarisationsschaltkreis einen Widerstand (RP) und einen Kondensator (C) umfasst.

4. Isolierschaltkreis nach Anspruch 1, dadurch gekennzeichnet, dass die Hochfrequenzspannungsquelle (20) von Mitteln gebildet ist, die zu der Einrichtung gehören, auf der der Isolierschaltkreis implantiert ist.

5. Isolierschaltkreis nach Anspruch 1, dadurch gekennzeichnet, dass im Falle eines symmetrischen Eingangssignals der Polarisationsschaltkreis zwei parallele Gleichrichterschaltkreise umfasst.

6. Isolierschaltkreis nach Anspruch 1, dadurch gekennzeichnet, dass im Fall eines symmetrischen Eingangssignals der Polarisierungsschaltkreis einen einzigen Gleichrichterschaltkreis umfasst.

**Claims**

1. Insulator circuit comprising an optoelectronic coupler (10) consisting of a photoemitting diode (DE) positioned facing a photodetector (DR), a photoemitting diode polarizing circuit, a signal input (E) connected to the photoemitting diode (DE) and an output amplifier (14) connected to the photodetector (DR), characterized in that the photoemitting diode polarizing circuit comprises a high frequency power supply (20) connected to a high frequency transformer (TR) and a rectifier circuit (22) inserted between said transformer (TR) and the photoemitting diode (DE).

2. Insulator circuit according to claim 1, characterized in that the rectifier circuit (22) comprises a diode (D) or diode bridge and a capacitor (C).

3. Insulator circuit according to claim 1, characterized in that the polarizing circuit comprises a resistor (RP) and a capacitor (C).

4. Insulator circuit according to claim 1, characterized in that the high frequency supply (20) is constituted by means belonging to the equipment on which the insulator circuit is installed.

5. Insulator circuit according to claim 1, characterized in that in the case of a symmetrical input signal, the polarizing circuit comprises two rectifier circuits in parallel.

6. Insulator circuit according to claim 1, characterized in that in the case of a symmetrical input signal, the polarizing circuit comprises a single rectifier circuit.

1/3

FIG.1

FIG.2

2,3

FIG.3

FIG.4

7

3,3

FIG.5

FIG.6